(19) **Europäisches Patentamt**
**European Patent Office**
**Office européen des brevets**

(11) **EP 4 715 401 A1**

(12) **EUROPÄISCHE PATENTANMELDUNG**

(43) Veröffentlichungstag:
25.03.2026 Patentblatt 2026/13

(51) Internationale Patentklassifikation (IPC):
*G01R 27/16* (2006.01)     *G01R 31/08* (2020.01)

(21) Anmeldenummer: 25194345.2

(52) Gemeinsame Patentklassifikation (CPC):
**G01R 31/086; G01R 27/16**

(22) Anmeldetag: 06.08.2025

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: 24.09.2024 AT 507832024

(71) Anmelder: **Sprecher Automation GmbH**
**4020 Linz (AT)**

(72) Erfinder: **Druml, Gernot**
**4212 Neumarkt im Mühlkreis (AT)**

(74) Vertreter: **Hübscher & Partner Patentanwälte GmbH**
**Spittelwiese 4**
**4020 Linz (AT)**

(54) **VERFAHREN ZUR ERMITTLUNG DER LEITUNGSIMPEDANZ IN SPANNUNGSNETZEN MIT NICHT STARR GEERDETEM STERNPUNKT**

(57)     Die Erfindung bezieht sich auf ein Verfahren zur Ermittlung der Leitungsimpedanz (13c) in Spannungsnetzen mit nicht starr geerdetem Sternpunkt (2), wobei die Stromwerte (I5) eines Leiters (5) sowie die Spannungswerte (U5) dieses Leiters (5) an einem Bezugspunkt (16) abgetastet werden. Um die auch bei einem nichtlinearen Verhalten des Spannungsnetzes im Erdschlussfall eine ressourcenschonende Ermittlung der Leitungsimpedanz und in weiterer Folge eine Fehlerortbestimmung zu ermöglichen, wird vorgeschlagen, dass bei einem Erdschluss (6) des Leiters (5) an einem Fehlerort (17) ein Fehlerspannungssignal (19) aus Spannungswerten nach dem Erdschlusseintritt (U5) sowie ein Fehlerstromsignal (18) aus Stromwerten nach dem Erdschlusseintritt (I5) und aus aus Stromwerten vor dem Erdschlusseintritt (I5) extrapolierten Extrapolationsstromwerten (I5E) ermittelt wird, wonach aus dem Fehlerstrom- und Fehlerspannungssignal (18,19) wenigstens näherungsweise die Leitungsimpedanz (13c) vom Bezugspunkt (16) bis zum Fehlerort (17) ermittelt wird.

FIG.1

EP 4 715 401 A1

**Beschreibung**

Die Erfindung bezieht sich auf ein Verfahren zur Ermittlung der Leitungsimpedanz in Spannungsnetzen mit nicht starr geerdetem Sternpunkt, wobei die Stromwerte eines Leiters sowie die Spannungswerte dieses Leiters an einem Bezugspunkt abgetastet werden. Die Erfindung bezieht sich auch auf ein davon abgeleitetes Verfahren zur Fehlerortbestimmung.

Zwar ergeben sich durch den Einsatz von nicht starr geerdeten Sternpunkten aufgrund des Fehlens eines direkten Erdungspfades bei einem etwaigen Erdschluss generell reduzierte Fehlerströme, sodass eine gewisse Ausfallsicherheit gegeben ist, jedoch besteht dennoch das Bedürfnis, den Fehlerort schnellstmöglich zu eruieren.

Aus dem Stand der Technik sind unterschiedliche Methoden bekannt, anhand des Quotienten aus der gemessenen Impedanz einer Leitung und der spezifischen Impedanz der Leitung pro Längeneinheit die Leitungslänge ausgehend von der Messstelle abzuschätzen. Diese Art der Entfernungsmessung eignet sich auch bei einem Kurzschluss zwischen zwei Leitern eines mehrphasigen Stromnetzes, da über die Messung von Strom und Spannung zwischen den Leitern die Schleifen-Impedanz einfach berechnet werden kann und der Fehlerstrom verglichen zum Strom nach der Fehlstelle hoch ist. Um eine möglichst exakte Fehlerortbestimmung zu ermöglichen, wird bei solchen Fehlerfällen vor der Impedanzmessung das Abklingen transienter Zustände abgewartet und/oder störende netzfrequenzfremde Signalanteile ausgefiltert.

In der EP3879280A1 wird zur Fehlerortbestimmung in einem mehrphasigen Spannungsnetz die Erdschleifenimpedanz bestimmt. Dort liegt die Erkenntnis zugrunde, dass der Aufladestrom zwischen dem fehlerbehafteten und den fehlerunbehafteten Leitern im Vergleich zum Erdschlussstrom sehr hoch ist und dass sich aufgrund des Erdschlusses ein Serienschwingkreis mit einer von der Netzfrequenz abweichenden Eigenfrequenz ausbildet, der den Aufladevorgang der fehlerunbehafteten Leiter maßgeblich beeinflusst. Durch Bestimmung der Eigenfrequenz des Serienschwingkreises, welche durch Abtasten der Strom-und Spannungswerte eines Leiters und einem anschließenden Vergleich mit der Netzfrequenz ermittelt werden kann, wird auf die Erdschleifenimpedanz geschlossen. Generell nachteilig bei Verfahren, die sich der Erdschleifimpedanz zur Fehlerortbestimmung mittels Eigenfrequenzbestimmung bedienen, ist, dass die gedämpfte Schwingung des Serienschwingkreis rasch abnimmt, was die exakte Erfassung der Eigenfrequenz erschwert. Auch Störfrequenzen, beispielsweise durch über die fehlerunbehafteten Leiter eingebrachte Störquellen, erschweren eine eindeutige Isolierung der Eigenfrequenz. Schließlich ergibt sich das Problem, dass bei Erdschlüssen nicht unbedingt Linearität gegeben sein muss, sodass vorgenommene Linearisierungen zu unzutreffenden Aussagen über die Eigenfrequenz führen können. Es wurde festgestellt, dass das Verfahren gemäß der EP3879280A1 nur dann exakte Ergebnisse liefert, wenn mehrere Perioden abgetastet werden und lineare Fehlerimpedanzen vorliegen, was insbesondere bei Mittelspannungsnetzen im Bereich von 10-35 kV kaum der Fall ist, sodass das aus der EP3879280A1 bekannte Verfahren dort verhältnismäßig ungenaue Ergebnisse liefert.

Der Erfindung liegt somit die Aufgabe zugrunde, ein ressourcenschonendes Verfahren zur Ermittlung der Leitungsimpedanz in Spannungsnetzen vorzuschlagen, das auch bei einem nichtlinearen Verhalten des Spannungsnetzes im Erdschlussfall eine repräsentative Bestimmung der Leitungsimpedanz und in weiterer Folge eine Fehlerortbestimmung ermöglicht.

Der Erfindung liegt die Überlegung zugrunde, dass im Falle eines Erdschlusses im Wesentlichen drei sich teilweise zeitlich überlappende Vorgänge ablaufen. Der erste Vorgang umfasst den quasistationären Betriebszustand der fehlerunbehafteten Leiter. Der zweite Vorgang umfasst eine durch den fehlerbehafteten Leiter erzeugte Entladeschwingung, wobei die beiden fehlerunbehafteten Leiter von diesen hohen Frequenzen entkoppelt sind. Der dritte Vorgang umfasst eine Aufladeschwingung, die sich durch die Anhebung des Spannungsniveaus der fehlerunbehafteten Leiter ergibt und die auch an dem fehlerbehafteten Leiter bestimmbar ist. Weiters kann erfindungsgemäß davon ausgegangen werden, dass die Brennspannung des Lichtbogens im Vergleich zur Netzspannung vernachlässigbar ist.

Die Erfindung löst die gestellte Aufgabe dadurch, dass bei einem Erdschluss des Leiters an einem Fehlerort ein Fehlerspannungssignal aus Spannungswerten nach dem Erdschlusseintritt sowie ein Fehlerstromsignal aus Stromwerten nach dem Erdschlusseintritt und aus aus Stromwerten vor dem Erdschlusseintritt extrapolierten Extrapolationsstromwerten ermittelt wird, wonach aus dem Fehlerstrom- und Fehlerspannungssignal wenigstens näherungsweise die Leitungsimpedanz vom Bezugspunkt bis zum Fehlerort ermittelt wird.

Zufolge der erfindungsgemäßen Merkmale kann der Einfluss von Nichtlinearitäten und anderen Störfaktoren weitgehend reduziert werden. Insbesondere kann erfindungsgemäß die Bestimmung von Eigenfrequenzen des sich ergebenden Schwingkreises entfallen. Es werden lediglich verhältnismäßig einfach zu bestimmende Fehlersignale von nur dem fehlerbehafteten Leiter, nämlich ein Fehlerspannungssignal und ein Fehlerstromsignal, zur Berechnung der Leitungsimpedanz benötigt, wobei davon ausgegangen wird, dass die Brennspannung des Lichtbogens vernachlässigbar im Vergleich zur Netzspannung ist und dass der Laststrom des fehlerbehafteten Leiters nach dem Erdschlusseintritt bis als annähernd konstant angenommen werden kann. Es hat sich überraschenderweise herausgestellt, dass zufriedenstellende Ergebnisse erreicht werden können, wenn das Fehlerstrom- und das Fehlerspannungssignal vom Erdschlusseintritt bis zum ersten lokalen Maximum oder dem ersten Nulldurchgang der abgetasteten Stromwerte des fehlerbehafteten Leiters für die Impedanzbestimmung herangezogen werden. Damit wird insbesondere die erste gemessene Stromhalbspitze berücksichtigt. Das Fehlerspannungssignal wird aus Spannungswerten nach dem Erdschlusseintritt durch Abtasten an dem Bezugspunkt bestimmt und entspricht im Wesentlichen, das heißt unter Vernachlässigung der Brennspannung des Lichtbogens, dem Betrag nach der über die Leitung bis zum Fehlerort abfallenden Spannung. Das Fehlerstromsignal wird aus den nach dem Erdschlusseintritt abgetasteten Stromwerten und Extrapolationsstromwerten bestimmt, die aus den Stromwerten vor dem Erdschlusseintritt abgeleitet werden. Dem liegt die Überlegung zugrunde, dass der quasistationäre Laststrom auch nach dem Erdschlusseintritt konstant ist. Im einfachsten Fall entspricht ein Extrapolationsstromwert nach dem Erdschlusseintritt dem Stromwert vor dem Erdschlusseintritt, der eine Periode der Netzgrundschwingung beabstandet ist. Es wird also davon ausgegangen, dass auch nach dem Erdschlusseintritt ein gleichbleibender Laststrom vorhanden ist. Aus dem Fehlerstrom - und Fehlerspannungssignal, welche insbesondere nach Entfernung eines Entladeschwingungsanteils des Leiters im Wesentlichen der Aufladeschwingung des Leiters entsprechen, kann wenigstens näherungsweise die Leitungsimpedanz vom Bezugspunkt bis zum Fehlerort ermittelt werden, und zwar mithilfe von aus dem Stand der Technik bekannten Verfahren wie insbesondere dem McInnes/Morrison Algorithmus. Dabei kann davon ausgegangen werden, dass der ohmsche Leitungswiderstand sowie Koppelinduktivitäten vom fehlerbehafteten zu den fehlerunbehafteten Leitern der anderen Abgänge im Vergleich zur Induktivität des fehlerbehafteten Leiters sehr klein sind, sodass sie für eine näherungsweise Bestimmung vernachlässigt werden können.

Für eine verbesserte Leitungsimpedanzbestimmung wird vorgeschlagen, dass aus dem Fehlerspannungssignal ein Entladeschwingungsanteil des fehlerbehafteten Leiters entfernt wird, bevor die Leitungsimpedanz ermittelt wird. Das ermittelte Fehlerspannungssignal kann entweder bereits mit so geringer Frequenz abgetastet werden, dass bereits durch diese Abtastung der Entladeschwingungsanteil des Leiters entfernt wird oder aber es kann bei höheren Abtastraten der Entladeschwingungsanteil durch den Einsatz eines Filters, beispielsweise eines Tiefpassfilters entfernt werden. In gleicher Weise kann grundsätzlich auch der Entladeschwingungsanteil aus dem Fehlerstromsignal entfernt werden.

Aufgrund der raschen Abklingzeit der Aufladeschwingung von wenigen Perioden der Aufladefrequenz sollte sichergestellt sein, dass nach dem Zeitpunkt des Erdschlusseintritts genügend Messwerte abgetastet werden können. Bei typischen Spannungsnetzen hat sich eine Abtastfrequenz von wenigstens 4kHz, vorzugsweise 6 - 40 kHz als vorteilhaft herausgestellt, um eine ausreichend hohe Messauflösung zu ermöglichen, ohne dabei eine erhöhte Rechenleistung zu bedingen. Der fehlerbehaftete Leiter wird vorzugsweise über wenigstens eine, vorzugsweise wenigstens zwei Perioden der Netzfrequenz nach und vor Erdschlusseintritt abgetastet. Das erfindungsgemäße Verfahren kann bei Erdschlussübergangswiderständen von bis zu 1000 Ohm, vorzugsweise bis zu 500 Ohm, eingesetzt werden. Bei hochohmigen Erdschlussübergangswiderständen kann es von Vorteil sein, für die Fehlerspannungs- und Fehlerstromsignale nicht nur die jeweiligen Abtastwerte vom Erdschlusseintritt bis zum ersten lokalen Maximum oder Nulldurchgang des Fehlerstromsignals, sondern über mehrere Perioden der Netzfrequenz heranzuziehen.

Eine besonders ressourcenschonende Leitungsimpedanzbestimmung wird dadurch ermöglicht, dass das Fehlerstromsignal als Differenz zwischen Stromwerten nach dem Erdschlusseintritt und den Extrapolationsstromwerten ermittelt wird.

Grundsätzlich kann der Entladeschwingungsanteil insbesondere bei höheren Abtastraten durch geeignete Filter, beispielsweise einen Tiefpass, entfernt werden. Besonders ressourcenschonenden Implementierungsbedingungen ergeben sich dabei, wenn der Entladungsschwingungsanteil durch eine gleitende Mittelwertbildung aus dem Fehlerstromsignal entfernt wird. Eine einfache Mittelwertbildung wird deshalb möglich, weil der Entladeschwingungsanteil wesentlich hochfrequenter als die Aufladeschwingung ist, sodass die hochfrequenten Schwingungsanteile durch eine einfache Glättung entfernt werden können. Hierzu können wenigstens 2, vorzugsweise wenigstens 7 Werte herangezogen werden.

Das erfindungsgemäße Verfahren kann zur Fehlerortbestimmung in Spannungsnetzen mit nicht starr geerdetem Sternpunkt eingesetzt werden. Hierzu wird die Leitungsimpedanz erfindungsgemäß ermittelt, wonach anhand eines Leitungsdatensatzes aus der Leitungsimpedanz die Entfernung vom Bezugspunkt zum Fehlerort bestimmt wird. Als Bezugspunkt können grundsätzlich unterschiedliche Messorte, wie der fehlerbehaftete Abgang an der Sammelschiene, ein fehlerbehafteter Abgang in der Tiefe, oder die Einspeisung im Sinne einer zentralen Distanzmessung gewählt werden.

Der Schluss von der Leitungsimpedanz auf die Entfernung vom Bezugspunkt zum Fehlerort kann durch die spezifische Leitungsimpedanz pro Meter, welche vom Leitungsdatensatz vorgegeben ist, errechnet werden.

$$Entfernung = \frac{ermittelte\ Leitungsimpedanz}{spezifische\ Leitungsimpedanz\ pro\ Meter}$$

Um eine robustere Ermittlung zu ermöglichen, können Algorithmen wie die Least-Squares-Methode herangezogen werden.

Wenn Leitungen mit unterschiedlichen Leitungsimpedanzen folgen (beispielsweise ein auf eine Freileitung gefolgten Kabel, deren Längen bekannt sind), kann die Entfernung vom Bezugspunkt zum Fehlerort dadurch eruiert werden, dass die bekannten Leitungsimpedanzen der jeweiligen Leiter bis zum Erreichen der bestimmten Leitungsimpedanz aufsummiert werden. Durch die bekannten Längen der jeweiligen Leiter kann auf die Entfernung vom Bezugspunkt zum Fehlerort geschlossen werden. Bei verzweigten Spannungsnetzen muss dieser Vorgang für jeden Zweig erfolgen. Zur diesbezüglichen Fehlereingrenzung können auf dem Wischerverfahren basierende, dezentral installierte Richtungsanzeiger vorgesehen sein. Das Wischerverfahren kann sich dabei dem qu-Algorithmus bedienen.

In der Zeichnung ist der Erfindungsgegenstand beispielsweise dargestellt. Es zeigen

Fig. 1    ein schematisches Blockschaltbild eines Spannungsnetzes mit nicht starr geerdetem Sternpunkt und einem fehlerbehafteten Leiter,
Fig. 2    ein beispielhaftes Diagramm der im Bezugspunkt gemessenen Ströme,
Fig. 3    ein beispielhaftes Diagramm des ermittelten Fehlerstromsignals
Fig. 4    ein beispielhaftes Diagramm der im Bezugspunkt gemessenen Spannungen und
Fig. 5    ein beispielhaftes Diagramm des ermittelten Fehlerspannungssignals.

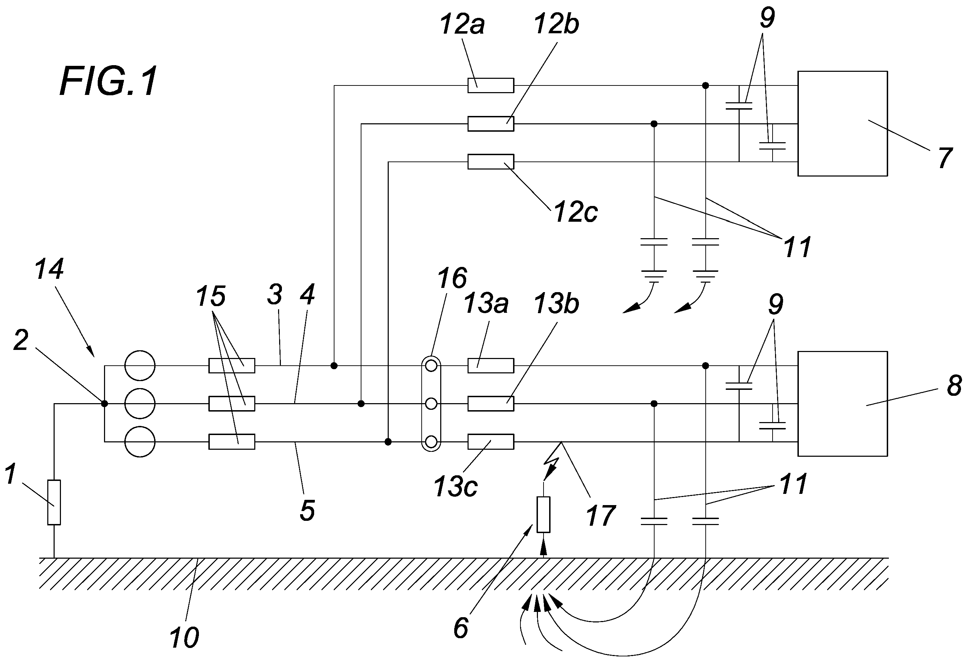

Ein Spannungsnetz mit einem nicht starr, beispielweise über eine Erdschlusslöschspule 1, geerdeten Sternpunkt 2 umfasst, wie in der Fig. 1 dargestellt, drei Leiter 3,4,5 wobei der Leiter 5 durch einen Erdschluss 6 fehlerbehaftet ist. Das Spannungsnetz kann mehrere Abgänge umfassen, wie dies schematisch angedeutet ist. Jeder Abgang ist dabei mit einer Last 7,8 versehen. Die Leiter 3,4,5 bilden untereinander Leitungskapazitäten 9 und zur Erde 10 Erdkapazitäten 11 aus. Die Leiter 3,4,5 selbst weisen je Abgang Leitungsimpedanzen 12a, 12b, 12c sowie 13a, 13b, 13c auf. Der das Netz speisende Transformator 14 weist eine Impedanz 15 auf.

Mithilfe des erfindungsgemäßen Verfahrens kann die Leitungsimpedanz 13c vom fehlerbehafteten Leiter 5 festgestellt werden und in weiterer Folge die Entfernung zwischen einem Bezugspunkt 16 zum Fehlerort 17 des Erdschlusses 6 festgestellt werden.

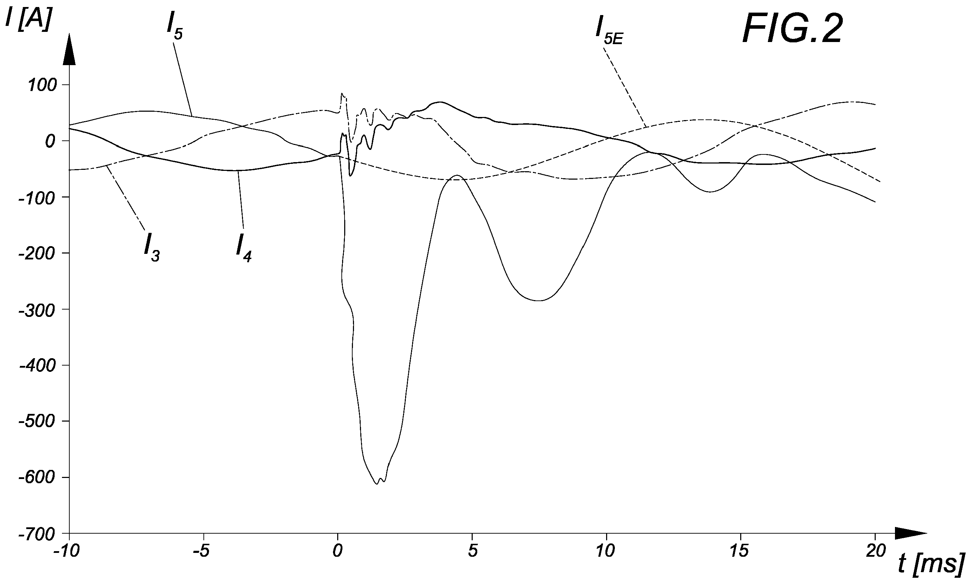

Hierzu werden in den Leitern 3, 4, 5 an einem Bezugspunkt 16 Strom- und Spannungswerte mit einer Abtastfrequenz von vorzugsweise 4kHz abgetastet. Die abgetasteten Stromwerte der fehlerunbehafteten Leiter $I_3$, $I_4$ sowie die Stromwerte des fehlerbehafteten Leiters $I_5$ bei Erdschluss 6 sind in Fig. 2 exemplarisch dargestellt. Hierbei ist zu entnehmen, dass der Erdschlussstrom im Leiter 5 vom quasistationären Laststrom überlagert ist.

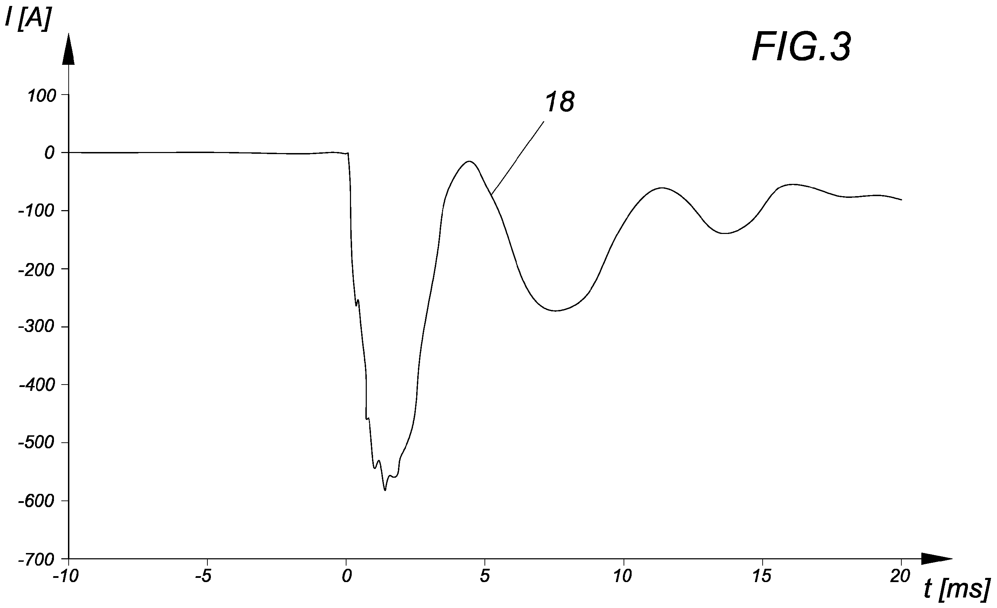

Erfindungsgemäß werden nun nach dem Eintritt des Erdschlusses 6 aus den Stromwerten vor dem Erdschlusseintritt Extrapolationsstromwerte $I_{5E}$ ermittelt, beispielsweise, in dem das Laststromsignal vor dem Erdschlusseintritt mit den jeweiligen periodenbezogenen Abtastwerten fortgesetzt wird, wie dies in Fig. 2 angedeutet ist. Aus den abgetasteten Stromwerten $I_5$ nach dem Erdschluss und den derart ermittelten Extrapolationsstromwerten $I_{5E}$ kann sodann ein in Fig. 3 dargestelltes Fehlerstromsignal 18 ermittelt werden, indem beispielsweise die Extrapolationsstromwerte $I_{5E}$ von den Stromwerten $I_5$ abgezogen werden. Es zeigt sich, dass dieses Fehlerstromsignal 18 vor dem Eintritt des Erdschlusses 6 zum Zeitpunkt 0 ms konstant 0 ist und danach eine negative Stromspitze ausbildet, die ein Vielfaches des Laststromes ausmacht. Diese Stromspitze repräsentiert den Aufladestrom, der vom Fehlerort 17 über die Leitungsimpedanz 13c fließt und dort einen Spannungsabfall generiert.

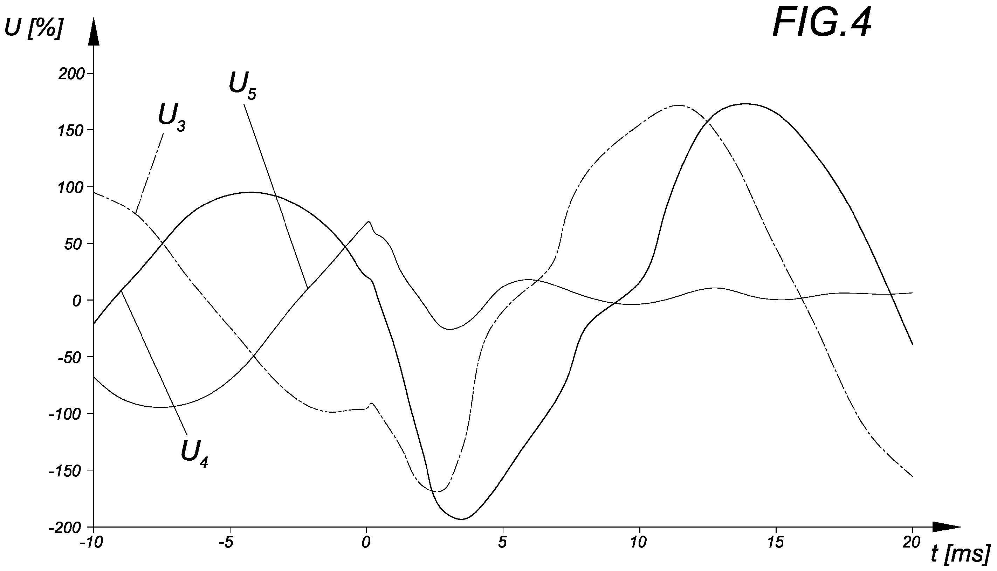

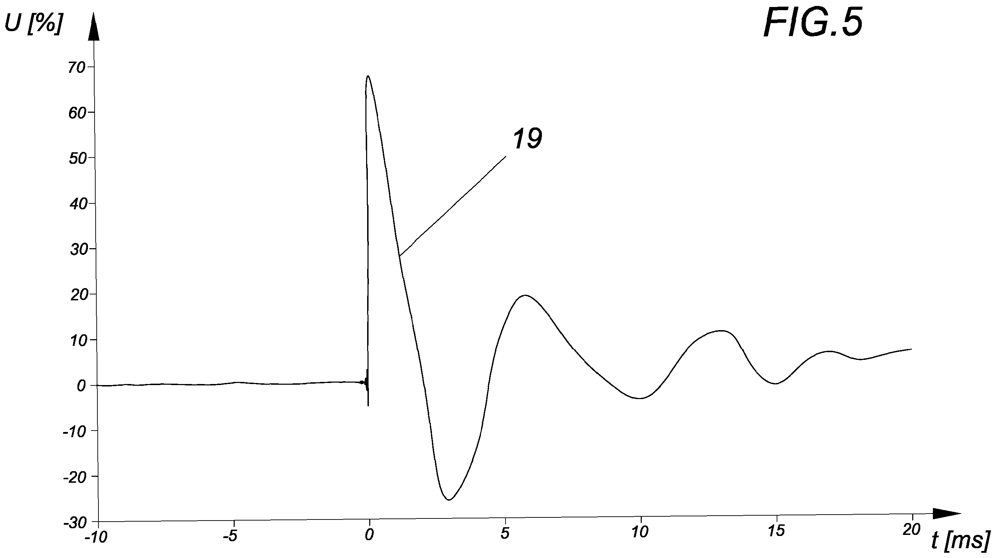

Analog zur Fig. 2 sind in der Fig. 4 die Spannungswerte der fehlerunbehafteten Leiter $U_3$, $U_4$ sowie die Stromwerte des fehlerbehafteten Leiters $U_5$ abgebildet. Aus den Spannungswerten des fehlerbehafteten Leiters $U_5$ nach Eintritt des Erdschlusses 6 zum Zeitpunkt 0 ms kann ein Fehlerspannungssignal 19 abgeleitet werden, wie dies in Fig. 5 in größerem Maßstab abgebildet ist. Das Fehlerspannungssignal 19 kann durch Tiefpassfilterung der Spannungswerte des fehlerbehafteten Leiters $U_5$ erzeugt werden, beispielsweise durch Abtastung mit entsprechend geringer Abtastfrequenz mit vorzugsweise 4 kHz, besonders bevorzugt weniger als 6 kHz oder durch eine gefensterte Mittelwertbildung. Dadurch werden die hochfrequenten Anteile der Entladeschwingung entfernt. Geht man weiters davon aus, dass die Brennspannung des Lichtbogens am Fehlerort 17 vernachlässigbar im Vergleich zur Netzspannung ist, entspricht das Fehlerspannungssignal 19 im Wesentlichen dem Spannungsabfall über den Leiter 5 vom Bezugspunkt 16 bis zum Fehlerort 17.

Somit ergeben sich ein Fehlerstromsignal 18 und ein Fehlerspannungssignal 19, aus dem über den Zusammenhang $u(t) = -L\frac{di}{dt}$ mit bekannten Methoden, wie beispielsweise dem McInnes - Morison Algorithmus auf Basis einer Darstellung als Integral, die Leitungsimpedanz 13c des fehlerbehafteten Leiters 5 ermittelt werden kann. Aus dieser Leitungsimpedanz 13c kann in weiterer Folge auf die Entfernung vom Bezugspunkt 16 zum Fehlerort 17 geschlossen werden, wenn für die einzelnen Abschnitte des Leiters 5 die spezifische Leitungsimpedanz pro Meter bekannt und beispielsweise in einem Leitungsdatensatz gespeichert ist.

**Patentansprüche**

1. Verfahren zur Ermittlung der Leitungsimpedanz (13c) in Spannungsnetzen mit nicht starr geerdetem Sternpunkt (2), wobei die Stromwerte ($I_5$) eines Leiters (5) sowie die Spannungswerte ($U_5$) dieses Leiters (5) an einem Bezugspunkt (16) abgetastet werden, **dadurch gekennzeichnet, dass** bei einem Erdschluss (6) des Leiters (5) an einem Fehlerort (17) ein Fehlerspannungssignal (19) aus Spannungswerten nach dem Erdschlusseintritt (Us) sowie ein Fehlerstromsignal (18) aus Stromwerten nach dem Erdschlusseintritt (Is) und aus aus Stromwerten vor dem Erdschlusseintritt (Is) extrapolierten Extrapolationsstromwerten ($I_{5E}$) ermittelt wird, wonach aus dem Fehlerstrom- und Fehlerspannungssignal (18,19) wenigstens näherungsweise die Leitungsimpedanz (13c) vom Bezugspunkt (16) bis zum Fehlerort (17) ermittelt wird.

2. Verfahren nach Anspruch 1, **dadurch gekennzeichnet, dass** aus dem Fehlerspannungssignal (19) ein Entladeschwingungsanteil des fehlerbehafteten Leiters (5) entfernt wird, bevor die Leitungsimpedanz (13c) ermittelt wird.

3. Verfahren nach Anspruch 1 oder 2, **dadurch gekennzeichnet, dass** das Fehlerstromsignal (18) als Differenz zwischen Stromwerten nach dem Erdschlusseintritt (Is) und den Extrapolationsstromwerten ($I_{5E}$) ermittelt wird.

4. Verfahren nach Anspruch 1 oder 2, **dadurch gekennzeichnet, dass** der Entladeschwingungsanteil durch eine gleitende Mittelwertbildung aus dem Fehlerspannungssignal (19) entfernt wird.

5. Verfahren zur Fehlerortbestimmung in Spannungsnetzen mit nicht starr geerdetem Sternpunkt (2), wobei die Stromwerte ($I_5$) eines Leiters (5) sowie die Spannungswerte ($U_5$) dieses Leiters (5) im Bereich des Abgangs einer Sammelschiene als Bezugspunkt (16) abgetastet werden, **dadurch gekennzeichnet, dass** bei einem Erdschluss (6) des Leiters (5) an einem Fehlerort (17) ein Fehlerspannungssignal (19) aus Spannungswerten nach dem Erdschlusseintritt (Us) sowie ein Fehlerstromsignal (18) aus Stromwerten nach dem Erdschlusseintritt (Is) und aus aus Stromwerten vor dem Erdschlusseintritt (Is) extrapolierten Extrapolationsstromwerten ($I_{5E}$) ermittelt wird, wonach aus dem Fehlerstrom - und Fehlerspannungssignal (18,19) wenigstens näherungsweise die Leitungsimpedanz (13c) vom Bezugspunkt (16) bis zum Fehlerort (17) ermittelt wird, wonach anhand eines Leitungsdatensatzes aus der Leitungsimpedanz (13c) die Entfernung vom Bezugspunkt (16) zum Fehlerort (17) bestimmt wird.

FIG.1

FIG.2

$I$ [A]

$I_5$

$I_{5E}$

100

0

-100

-200

-300

-400

-500

-600

-700

$I_3$

$I_4$

-10        -5        0        5        10        15        20        $t$ [ms]

EP 4 715 401 A1

FIG.3

FIG.4

EP 4 715 401 A1

FIG.5

EP 4 715 401 A1

**EUROPÄISCHER RECHERCHENBERICHT**

Europäisches Patentamt
European Patent Office
Office européen des brevets

Nummer der Anmeldung

EP 25 19 4345

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | CN 107 632 238 A (STATE GRID LIAONING ELECTRIC POWER SUPPLY CO LTD ET AL.) 26. Januar 2018 (2018-01-26) * Zusammenfassung * * Absatz [0029] - Absatz [0035]; Anspruch 2; Abbildung 2 * ----- | 1-5 | INV. G01R27/16 G01R31/08 |
| A | US 2021/075210 A1 (WAHLROOS ARI [FI] ET AL) 11. März 2021 (2021-03-11) * Zusammenfassung * * Absatz [0028] - Absatz [0029]; Abbildung 1 * * Absatz [0077] - Absatz [0085] * ----- | 1-5 | |
| A,D | EP 3 879 280 A1 (SPRECHER AUTOMATION GMBH [AT]) 15. September 2021 (2021-09-15) * Zusammenfassung * * Absatz [0010]; Abbildung 1 * * Absatz [0011]; Abbildung 2 * ----- | 1-5 | |

RECHERCHIERTE SACHGEBIETE (IPC)

G01R
H02H

Der vorliegende Recherchenbericht wurde für alle Patentansprüche erstellt

| Recherchenort | Abschlußdatum der Recherche | Prüfer |
|---|---|---|
| München | 13. Januar 2026 | Jakob, Clemens |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 19 4345

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-01-2026

| Im Recherchenbericht angeführtes Patentdokument | Datum der Veröffentlichung | Mitglied(er) der Patentfamilie | Datum der Veröffentlichung |
|---|---|---|---|
| CN 107632238 A | 26-01-2018 | KEINE | |
| US 2021075210 A1 | 11-03-2021 | EP 3570400 A1 | 20-11-2019 |
| | | ES 2911035 T3 | 17-05-2022 |
| | | US 2021075210 A1 | 11-03-2021 |
| | | WO 2019219897 A1 | 21-11-2019 |
| EP 3879280 A1 | 15-09-2021 | AT 523595 A1 | 15-09-2021 |
| | | EP 3879280 A1 | 15-09-2021 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3879280 A1